(19) **Europäisches Patentamt** / **European Patent Office** / **Office européen des brevets**

(11) **EP 3 610 272 B1**

(12) **FASCICULE DE BREVET EUROPEEN**

(45) Date de publication et mention
de la délivrance du brevet:
**26.02.2025 Bulletin 2025/09**

(21) Numéro de dépôt: **18717915.5**

(22) Date de dépôt: **12.04.2018**

(51) Classification Internationale des Brevets (IPC):
***G01R 15/20*** *(2006.01)*

(52) Classification Coopérative des Brevets (CPC):
**G01R 15/207;** G01R 19/0092; G01R 19/2513

(86) Numéro de dépôt international:
**PCT/EP2018/059449**

(87) Numéro de publication internationale:
**WO 2018/189327 (18.10.2018 Gazette 2018/42)**

(54) **PROCÉDÉ DE MESURE DE L'INTENSITÉ D'UN COURANT DANS UN CONDUCTEUR**

VERFAHREN ZUR MESSUNG DER INTENSITÄT EINES STROMES IN EINEM LEITER

METHOD FOR MEASURING THE INTENSITY OF A CURRENT IN A CONDUCTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.04.2017 FR 1753267**

(43) Date de publication de la demande:
**19.02.2020 Bulletin 2020/08**

(73) Titulaires:
• **Institut Polytechnique de Grenoble**
  **38000 Grenoble (FR)**
• **Centre National de la Recherche Scientifique**
  **75016 Paris Cedex 16 (FR)**

(72) Inventeurs:
• **CUGAT, Orphée**
  **38031 Grenoble Cedex 1 (FR)**
• **DELAMARE, Jérôme**
  **38031 Grenoble Cedex 1 (FR)**
• **PINAUD, Olivier**
  **38031 Grenoble Cedex 1 (FR)**
• **ROUVE, Laure-Line**
  **38570 Theys (FR)**
• **WILSCH, Benjamin**
  **38031 Grenoble Cedex 1 (FR)**

(74) Mandataire: **Hautier IP**
**20, rue de la Liberté**
**06000 Nice (FR)**

(56) Documents cités:
WO-A1-2013/068360    WO-A1-2015/030871
DE-A1- 10 003 584    DE-A1- 19 813 890

**Description**

La présente invention concerne un procédé de mesure de l'intensité d'un courant dans un conducteur électrique. La présente invention concerne également un procédé de conception d'un capteur de mesure. La présente invention concerne également un calculateur, un capteur de courant et un système de mesure associés.

Des capteurs de mesure de courant sont utilisés dans de nombreuses applications pour évaluer l'intensité de courants traversant des conducteurs. Par exemple, de tels capteurs permettent une gestion des réseaux de distribution d'électricité et sont alors installés en différents points des réseaux afin d'évaluer la consommation effective des différentes installations alimentées et/ou de surveiller l'état général du réseau. Les informations récoltées sont ensuite utilisées pour gérer au mieux le réseau de distribution.

De nombreux capteurs utilisés dans de telles applications évaluent le courant traversant un conducteur par des mesures de champs magnétiques créés par la circulation du courant dans le conducteur. Par exemple, des tores de Rogowski, ou encore des ensembles de magnétomètres sont disposés autour du conducteur pour estimer la valeur de l'intensité du courant. Selon un autre exemple, le document de brevet WO2015/030871 A1 divulgue un système de mesure dans lequel des magnétomètres sont insérés à l'intérieur du conducteur dont l'intensité est à mesurer ; la mesure réalisée par le système selon ce document est donc invasive et son installation ne peut se faire a posteriori, du courant circulant dans le conducteur.

Par ailleurs, les réseaux de distribution d'électricité sont fréquemment des réseaux polyphasés, en particulier triphasés, dans lesquels des courants circulent simultanément dans des conducteurs proches les uns des autres. Dans ces conditions, les champs magnétiques à proximité d'un conducteur sont modifiés de manière significative par des courants circulant dans les conducteurs voisins. La mesure, grâce à ces capteurs, de l'intensité du courant peut alors être moins précise. Il est alors nécessaire de réaliser un blindage de ces capteurs pour éviter ou au moins réduire l'influence des perturbations extérieures, ce qui complexifie la réalisation de ces capteurs et augmente leurs dimensions.

En outre, les capteurs précités doivent être placés autour du conducteur à mesurer pour obtenir une précision suffisante. L'installation de ces capteurs est donc contraignante, et suppose parfois que les conducteurs soient détachés à une extrémité pour que le capteur soit enfilé autour du conducteur. Même lorsque ce n'est pas le cas, la mise en place est en général une opération complexe et longue qui implique fréquemment la coupure du courant dans le conducteur. La mise en place des capteurs est donc contraignante pour le gestionnaire du réseau puisqu'elle suppose une indisponibilité temporaire d'une partie du réseau.

Le document de brevet WO2013/068360 A1 présente un système de mesure relatif au contexte développé dans ces deux derniers paragraphes et présentant au moins les inconvénients qui y sont énoncés.

Il existe donc un besoin pour un procédé de mesure de l'intensité d'un courant circulant dans un conducteur électrique, qui soit à la fois précis, de petites dimensions et plus facile à installer que les procédés de mesure de l'état de la technique.

A cet effet, il est proposé un procédé de mesure selon la revendication 1 annexée.

De manière facultative, le procédé de mesure peut en outre présenter au moins l'une quelconque des caractéristiques énoncées aux revendications 2 à 5 annexées.

Il est également proposé un procédé de conception d'un capteur de mesure comportant une pluralité de détecteurs de champ magnétique, le procédé de conception déterminant, pour une précision de mesure souhaitée, le nombre de détecteurs de champ magnétique, ainsi que le positionnement spatial des détecteurs, en utilisant le procédé de mesure défini ci-dessus.

Il est également proposé un calculateur selon la revendication 7 annexée.

Il est également proposé un capteur de courant configuré pour mesurer une intensité d'un courant traversant un conducteur électrique, le capteur de courant comprenant une pluralité de détecteurs de champ magnétique et un calculateur tel que défini ci-dessus, chaque détecteur étant configuré pour mesurer la valeur du champ magnétique selon une direction en un point de mesure, chaque point de mesure étant distinct et à une distance d'un point de référence, et pour transmettre la valeur mesurée au calculateur.

Il est également proposé un système de mesure de courants traversant une pluralité de conducteurs électriques, le système de mesure comprenant une pluralité de capteurs de courant tels que définis ci-dessus et un unique contrôleur central, chaque capteur étant configuré pour communiquer avec le contrôleur central.

Des caractéristiques et avantages de l'invention apparaîtront à la lecture de la description qui va suivre, donnée uniquement à titre d'exemple non limitatif et faite en référence aux dessins annexés, sur lesquels :

- la figure 1 est une représentation schématique partielle d'un réseau de distribution d'électricité équipé d'un premier exemple de capteur de courant comprenant un ensemble de détecteurs de champ magnétique,
- la figure 2 est un ordinogramme des étapes d'un procédé de mesure de courant mis en oeuvre par le capteur de la figure 1, comprenant une étape de calibration,
- la figure 3 est une représentation schématique d'un exemple d'ensemble de détecteurs de la figure 1, et

- la figure 4 est une représentation schématique d'un ensemble de détecteurs de champ magnétique d'un deuxième exemple de capteur de courant, et
- la figure 5 est un ordinogramme des étapes d'un exemple d'étape de calibration de la figure 2.

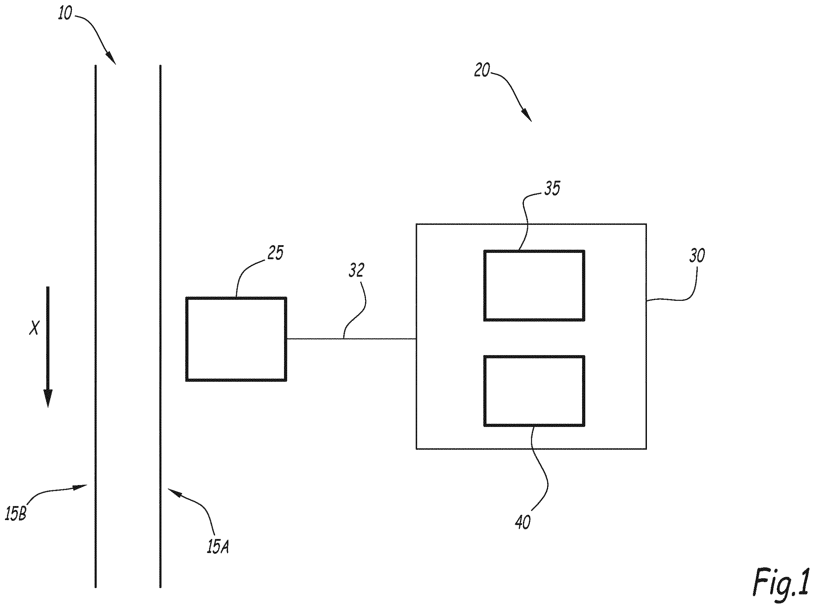

Un réseau 10 de distribution d'électricité a été partiellement représenté sur la figure 1.

Le réseau 10 comprend une pluralité de conducteurs 15A, 15B. Selon l'exemple de la figure 1, la pluralité de conducteurs comprend un premier conducteur 15A et au moins un deuxième conducteur 15B.

Le réseau 10 est, en outre, équipé d'au moins un premier exemple de capteur de courant 20.

Chaque conducteur 15A, 15B est configuré pour recevoir un courant électrique d'un tableau de répartition et pour transmettre le courant électrique à une installation électrique correspondante.

Chaque courant électrique est, par exemple, un courant continu.

En variante, au moins un courant électrique est un courant alternatif.

Une intensité IA, IB et une tension électrique Ua, Ub sont définies pour chaque courant électrique traversant un conducteur 15A, 15B.

Chaque tension électrique Ua, Ub peut être comprise entre 50 volts (V) et 75 kilovolts (kV). Par exemple, chaque tension électrique est égale à 20 kV.

Chaque capteur de courant 20 est configuré pour déterminer l'intensité IA, IB, d'au moins un courant électrique. Selon l'exemple de la figure 1, le capteur de courant 20 est configuré pour mesurer l'intensité IA du courant traversant le premier conducteur 15A.

Chaque capteur de courant 20 comporte un ensemble 25 de détecteurs 27 de champ magnétique et un calculateur 30.

Dans un souci de clarté, un seul ensemble 25 a été représenté sur la figure 1, et est décrit dans la description ci-dessous. Cependant, il est à noter qu'un même capteur 20 est susceptible de comporter une pluralité d'ensembles 25. Par exemple, selon une variante le capteur de courant 20 comporte deux ensembles 25, un pour chaque conducteur 15A, 15B.

L'ensemble 25 est configuré pour déterminer un nombre Nv de valeurs de composantes du champ magnétique Cm. En particulier, l'ensemble 25 est configuré pour déterminer simultanément le nombre Nv de valeurs. Il est entendu par « simultanément » que les valeurs sont déterminées au cours d'un même intervalle de temps. Chaque intervalle de temps est relativement court comparativement au temps de fluctuation des courants à mesurer.

Par exemple, le nombre de valeurs Nv est supérieur ou égal à 10.

Chaque détecteur 27 est configuré pour mesurer une valeur Gm en un point de mesure Pm d'au moins une composante du champ magnétique Cm selon une direction de mesure Dm.

Dans la suite de cette description, chaque point de mesure Pm sera repéré par un indice i allant de 1 à un premier nombre N1.

Selon une variante, chaque détecteur 27 est configuré pour mesurer des valeurs Gm d'une pluralité de composantes du champ magnétique en un unique point de mesure $Pm_i$. Par exemple, chaque détecteur 27 est configuré pour mesurer des valeurs Gm de deux composantes du champ magnétique en un unique point de mesure $Pm_i$. En variante, chaque détecteur 27 est configuré pour mesurer des valeurs Gm de trois composantes du champ magnétique en un unique point de mesure $Pm_i$.

Chaque point de mesure $Pm_i$ associé à une direction de mesure Dm est distinct des autres points de mesure $Pm_i$ associés à la même direction de mesure Dm. Par exemple, l'ensemble 25 est configuré pour acquérir simultanément une unique valeur Gm d'une composante du champ magnétique Cm selon une direction de mesure Dm en chaque point de mesure $Pm_i$.

Chaque direction de mesure Dm est, par exemple, définie de manière absolue. Des directions d'un repère cartésien sont des exemples de directions définies de manière absolue.

En variante, chaque direction de mesure Dm est définie relativement au point de mesure considéré. Par exemple, des directions radiale et orthoradiale d'un repère muni de coordonnées cylindriques sont des exemples de directions définies de manière relative.

Selon un autre mode de réalisation, l'ensemble 25 est configuré pour acquérir simultanément une pluralité de valeurs Gm de composantes du champ magnétique Cm selon des directions de mesure Dm en chaque point de mesure $Pm_i$, seules des valeurs de composantes selon des directions de mesure Dm distinctes étant acquises simultanément en un même point de mesure $Pm_i$.

Chaque détecteur 27 est configuré pour transmettre les valeurs Gm mesurées au calculateur 30. Par exemple, chaque détecteur 27 est relié au calculateur 30 par une liaison filaire 32. En variante, chaque détecteur 27 est configuré pour transmettre au calculateur 30 les valeurs Gm mesurées par communication radiofréquence.

Le calculateur 30 est configuré pour mettre en oeuvre un procédé de mesure de l'intensité IA du courant dans le premier conducteur 15A.

Le calculateur 30 comporte une mémoire 35 et un processeur 40.

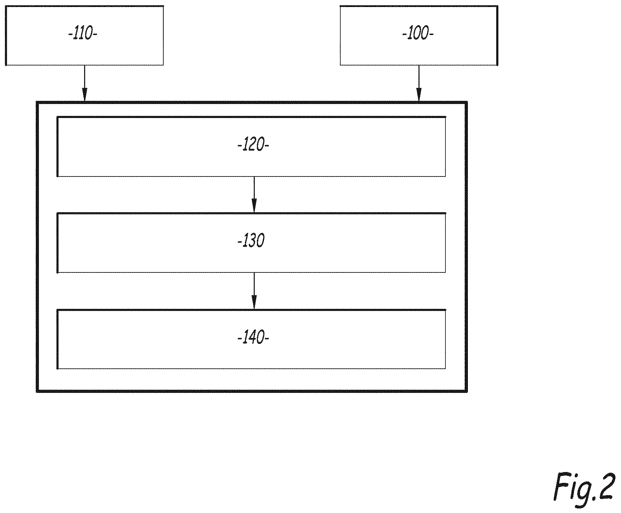

Le fonctionnement du capteur 20 va maintenant être décrit. Un ordinogramme des étapes d'un procédé de mesure de l'intensité IA du courant traversant le premier conducteur 15A a été représenté sur la figure 2.

Le procédé de mesure comprend une étape 100 de calibration, une étape 110 d'obtention d'une matrice, une étape 120 de formation, une étape 130 de calcul et une étape 140 de détermination.

Au cours du procédé de mesure, l'ensemble 25 est dans une position de fonctionnement.

Lorsque l'ensemble 25 est dans la position de fonctionnement, l'ensemble 25 est disposé à proximité du premier conducteur 15A.

Par exemple, l'ensemble 25 est fixé au premier conducteur 15A par un bras de fixation dédié.

Lorsque l'ensemble 25 est dans la position de fonctionnement, l'ensemble 25 est distant de chaque conducteur 15A, 15B. En particulier, l'ensemble 25 est distant du premier conducteur 15A. Il est entendu par « distant » qu'aucun point du premier conducteur 15A n'appartient à une surface plane délimitée par trois segments reliant toute combinaison de trois points de mesure $Pm_i$, ni à un segment reliant toute combinaison de deux points de mesure $Pm_i$. En particulier, les volumes définis par l'ensemble des points de mesure $Pm_i$ et le conducteur sont disjoints.

Une première distance d1 est définie entre le point de référence Pr et le point du premier conducteur 15A le plus proche du point de référence Pr. Le maximum des distances $r_i$ des points de mesure $Pm_i$, autour de Pr, est strictement inférieur à la première distance d1. En d'autres termes, le capteur 20 est physiquement disjoint du premier conducteur 15A. Par exemple, le maximum des distances $r_i$ des points de mesure $Pm_i$ est inférieur ou égal à 85 pourcents (%) de la première distance d1.

Une deuxième distance d2 est définie entre le détecteur 27 le plus proche du premier conducteur 15A et le point du premier conducteur 15A le plus proche du détecteur 27 considéré.

Une troisième distance d3 est définie entre le point de référence Pr et le point le du second conducteur 15B le plus proche du point de référence Pr. La troisième distance d3 est supérieure ou égale à la première distance d1.

Au cours de l'étape de calibration 100, un ensemble de coefficients de conversion K est calculé.

Chaque coefficient de conversion K est un nombre réel. L'étape 100 est, par exemple, mise en oeuvre une seule fois lorsque le capteur 20 est installé dans sa position de fonctionnement. En variante, l'étape 100 est mise en oeuvre lorsque des indices donnent à penser que le capteur 20 a été déplacé par rapport aux conducteurs 15A, 15B.

Lors de l'étape 110 d'obtention d'une matrice, une matrice de calcul M est obtenue par le calculateur 30. Par exemple la matrice de calcul M est mémorisée dans la mémoire 35.

La matrice de calcul M est calculée en fonction de la position relative des différents points de mesure Pm par rapport au point de référence Pr. Par exemple, l'étape d'obtention 110 est mise en oeuvre une seule fois lors de la conception du capteur 20.

La matrice de calcul M comprend un ensemble de termes T.

Les termes T sont agencés en un ensemble de lignes L et de colonnes C de la matrice de calcul M.

La matrice de calcul M comprend le nombre de valeurs Nv de lignes L. La matrice de calcul comprend un deuxième nombre N2 de colonnes C. Chaque ligne L comprend ainsi le deuxième nombre N2 de termes T.

Chaque terme T de la matrice de calcul M est une fonction élémentaire d'une décomposition en harmoniques spatiales du champ magnétique Cm.

Il est entendu par « décomposition en harmoniques spatiales » qu'une valeur de chaque composante du champ magnétique Cm est susceptible d'être calculée, en tout point de l'espace, comme une somme infinie de produits. Chaque produit intervient entre un coefficient et la fonction élémentaire correspondante.

Chaque coefficient est un nombre.

Chaque fonction élémentaire est une fonction définie pour tout point de l'espace et dépendant de la position du point considéré dans l'espace.

Selon le principe de la décomposition en harmoniques spatiales, les fonctions élémentaires sont identiques quelles que soit le champ magnétique Cm considéré, mais chaque champ magnétique Cm est entièrement défini par les valeurs correspondantes des coefficients. En d'autres termes, les fonctions élémentaires forment une base dans laquelle le champ magnétique Cm est susceptible d'être décrit.

En particulier, chaque fonction élémentaire est une fonction de la position du point considéré par rapport à un point de référence Pr. Par exemple, chaque fonction élémentaire est une fonction d'une puissance de la distance $r_i$ entre le point considéré et le point de référence. Dans la suite de cette description, le terme « ordre » est utilisé pour signifier « puissance » au sens de la phrase précédente.

Ainsi, chaque terme T est une fonction de la position d'un point de mesure $Pm_i$ correspondant par rapport au point de référence Pr. Par exemple, chaque terme T d'une même ligne L est une fonction de la position d'un même point de mesure $Pm_i$ correspondant à un détecteur 27.

En particulier, chaque terme T est proportionnel à une distance $r_i$ entre le point de mesure $Pm_i$ correspondant et le point de référence Pr, élevée à une puissance supérieure ou égale à zéro.

Un ordre maximum N est défini comme étant l'ordre maximum des termes de la décomposition en harmoniques spatiales du champ magnétique. En d'autres termes, la somme infinie de termes est tronquée pour donner une approximation suffisante du champ magnétique avec un nombre fini de termes, dépendant de l'ordre maximum N.

L'ordre N est, par exemple, égal à 4.

Par exemple, chaque ligne L de la matrice de calcul M comprend autant de termes T qu'il a été défini de fonctions élémentaires associées aux ordres entre 0 et l'ordre maximum N.

Chaque terme T d'une même colonne C est proportionnel à une distance $r_i$ élevée à une puissance identique pour tous les termes T de la colonne C.

Au cours de l'étape de formation 120, chaque détecteur 27 mesure une valeur Gm d'une composante de champ magnétique en le point de mesure $Pm_i$ correspondant.

Le calculateur 30 reçoit les valeurs Gm mesurées des détecteurs 27. Un vecteur de mesure B est alors formé.

Par exemple, le vecteur de mesure B comprend le nombre de valeurs Nv de composantes $b_l$, où l est un indice. Chaque composante $b_l$ est une valeur Gm d'une composante de champ magnétique mesurée. Chaque composante $b_l$ est associée à une ligne de la matrice de calcul M et est identifiée par l'indice l correspondant.

Les composantes $b_l$ sont ordonnées dans le vecteur B dans l'ordre des indices l croissants. Chaque composante $b_l$ est mesurée en le point de mesure $Pm_i$ associé à la ligne L correspondante.

Au cours de l'étape 130 de calcul, un vecteur de coefficients A est calculé par le processeur 40.

Le vecteur de coefficient A comprend le deuxième nombre N2 de composantes $\alpha$.

Les valeurs réelles des composantes $\alpha$ du vecteur A de coefficients sont telles que la relation matricielle :

$$B = M \times A \qquad \text{(Equation 1)}$$

dans laquelle « x » dénote l'opération de multiplication matricielle, est vérifiée.

En d'autres termes, les composantes du vecteur de coefficients A sont calculées par la résolution du problème inverse de l'équation 1 ci-dessus.

Ainsi, le capteur 20 étant disjoint du premier conducteur 15A, l'équation 1 correspond à la résolution d'un problème interne avec une décomposition en harmoniques spatiales en puissance croissante de la distance $r_i$ par rapport au point de référence Pr.

L'équation 1 décrit une décomposition en harmoniques spatiales des valeurs de champ magnétique mesurées, dans laquelle seuls un nombre de produits égal au résultat de la multiplication du nombre de valeurs Nv et du deuxième nombre N2 sont calculés.

Chaque composante $\alpha$ est alors un coefficient de la décomposition du champ magnétique Cm en harmoniques spatiales.

Chaque composante $\alpha$ calculée par l'équation 1 précédente est également appelée valeur réelle de la composante $\alpha$.

Chaque composante $\alpha$ du vecteur de coefficients A est uniquement proportionnelle au courant IA traversant le premier conducteur 15A lorsqu'aucune autre source de champ magnétique n'est présente, par exemple lorsqu'aucun courant IB ne traverse le deuxième conducteur 15B et que l'environnement magnétique est négligeable. Chaque coefficient de conversion K est calculé au cours de l'étape de calibration 100 à partir d'une fonction mathématique reliant une valeur d'une composante $\alpha$ et le courant IA traversant le premier conducteur 15A.

Lors de l'étape de détermination 140, l'intensité IA du courant traversant le premier conducteur 15A est déterminée à partir des composantes $\alpha$ calculées du vecteur de coefficients A.

La détermination de l'intensité IA comprend la division d'une valeur réelle d'un coefficient $\alpha$ par un coefficient de conversion K correspondant.

L'intensité IA est, par exemple, égale au résultat de la division d'une valeur réelle d'un coefficient $\alpha$ associé à la plus haute valeur de puissance, c'est-à-dire à l'ordre maximal N, par le coefficient de conversion K correspondant. Ainsi, lorsque les coefficients de conversion K sont connus et les composantes $\alpha$ déterminées grâce à l'équation 1 précédente, le courant IA traversant le premier conducteur 15A est calculé précisément.

Le procédé de mesure mis en oeuvre par le capteur 20 utilise avantageusement le fait que les sources éloignées de l'ensemble 25 présentent une contribution plus faible aux coefficients que les sources proches de l'ensemble 25, et ce d'autant plus que l'ordre associé au coefficient $\alpha$ augmente. En particulier, le procédé de mesure est moins sensible au courant IB traversant le deuxième conducteur 15B, lorsque le deuxième conducteur 15B est plus éloigné de l'ensemble 25. Cette sensibilité est d'autant plus faible que les coefficients $\alpha$ sont associés à un ordre élevé. Ainsi, le procédé présente une meilleure précision que les procédés de mesure de l'état de la technique, en s'affranchissant mathématiquement des sources de champ autres que le courant IA que l'on cherche à mesurer, tout en évitant tout besoin de mise en oeuvre d'un système de blindage.

En outre, le procédé de mesure est susceptible d'être mis en oeuvre par un capteur 20 disposé à proximité du conducteur 15A dont l'intensité du courant est à mesurer mais n'entourant pas ce conducteur 15A. La mise en place du capteur 20 est ainsi facilitée. En particulier, la mise en place du capteur 30 ne suppose pas une coupure du courant circulant dans le conducteur 15A étudié.

Le premier exemple a été décrit dans le cas où l'intensité IA est déterminée par la division d'une valeur réelle d'un

coefficient $\alpha$ associé à la plus haute valeur de la puissance, c'est-à-dire à l'ordre maximum N, par le coefficient de conversion K correspondant. Il est à noter que l'intensité IA est susceptible d'être obtenue à partir d'ordres différents de l'ordre maximum N. Cela est en particulier le cas si plusieurs ensembles 25 distincts et présentant des points de référence Pr distincts sont intégrés à un même capteur 20.

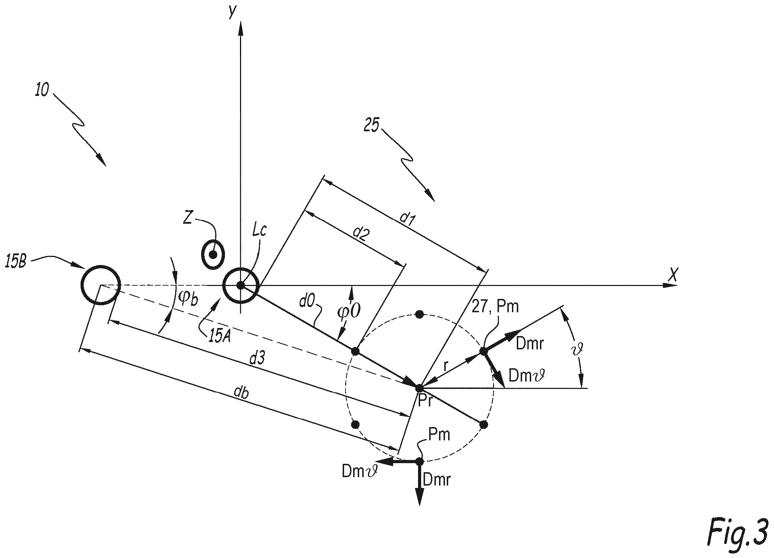

Un deuxième exemple d'ensemble 25 de détecteurs 27 a été représenté de manière schématique, dans sa position de fonctionnement, sur la figure 3.

Chaque conducteur 15A, 15B s'étend selon une direction principale Z

Chaque conducteur 15A, 15B présente une forme selon des sections perpendiculaires à la direction principale Z. Par exemple, chaque conducteur 15A, 15B est cylindrique à base circulaire. Dans ce cas, l'intersection d'un conducteur 15A, 15B avec un plan perpendiculaire à la direction principale Z est un disque. La réunion des centres de chaque disque d'un même conducteur 15A, 15B forme alors un segment parallèle à la direction principale Z et appelé ligne centrale Le du conducteur 15A, 15B considéré.

Une longueur, selon la direction principale Z, est définie pour chaque conducteur. La longueur est, par exemple 1 mètre (m) de part et d'autre de l'ensemble 25. De telles dimensions permettent de considérer le champ magnétique comme invariant selon la direction principale Z.

Une direction X et une direction Y ont été représentées sur la figure 3. Les directions X et Y sont perpendiculaires l'une à l'autre ainsi qu'à la direction principale Z et forment avec la direction principale Z un repère cartésien centré sur le point de référence Pr.

La position de la ligne centrale Le du premier conducteur 15A, est repérée dans un repère polaire, de centre le point de référence Pr, associé au repère (XYZ) par ses coordonnées polaires $(d0, \varphi0)$. Ici d0 est la distance, mesurée dans un plan perpendiculaire à la direction principale Z, entre le point de référence et un point appartenant à la ligne centrale Le du premier conducteur 15A, et $\varphi0$ est l'angle entre la direction X et un segment reliant le point de référence Pr au point appartenant à la ligne centrale Le précitée.

La position dans l'espace de la ligne centrale Le du premier conducteur 15A par rapport au point de référence Pr est, par exemple, une position supposée dans laquelle le bras est prévu pour fixer le point de référence Pr. En d'autres termes, les valeurs de l'angle $\varphi0$ et de la distance d0 sont fixées par construction de l'ensemble de capteurs 25 et de leur support, et par le choix des directions Y et Z utilisées pour le procédé de mesure.

L'angle $\varphi0$ est, par exemple, égal à 180 degrés (°).

La distance d0 est, par exemple, égale à 10 centimètres (cm).

La position de chaque point de mesure $Pm_i$ est définie, par rapport au point de référence Pr, par un ensemble d'un angle $\vartheta_i$ et d'une distance $r_i$ mesurée dans un plan perpendiculaire à la direction principale Z entre le point de mesure $Pm_i$ et le point de référence Pr. L'angle $\vartheta_i$ est, par exemple, l'angle entre la direction X et un segment reliant le point de mesure $Pm_i$ et le point de référence Pr.

Afin de clarifier la figure 3, seuls six détecteurs 27 ont été représentés.

Selon l'exemple de la figure 3, les points de mesure $Pm_i$ sont agencés le long d'un cercle. Par exemple, le cercle est compris dans un plan perpendiculaire à la direction principale Z.

Par exemple, les points de mesure $Pm_i$ sont angulairement équirépartis le long du cercle, c'est-à-dire qu'un angle entre un point de mesure $Pm_i$, le centre du cercle et l'un des deux points de mesure $Pm_i$ voisins est identique à l'angle entre le point de mesure $Pm_i$ considéré, le centre du cercle et l'autre point de mesure $Pm_i$ voisin.

Le cercle présente, par exemple, un rayon compris entre 2 cm et 5 cm. Il est à noter que différentes valeurs de rayon sont envisageables en fonction de l'agencement des conducteurs 15A, 15B et des courants IA, IB considérés. Le point de référence Pr est, par exemple, le centre du cercle sur lequel sont agencés les points de mesure $Pm_i$.

Selon l'exemple de la figure 3, chaque direction de mesure Dm est définie dans un repère dépendant du point de mesure $Pm_i$ correspondant.

Par exemple, chaque direction de mesure Dm est une direction orthoradiale ou une direction radiale. Une direction orthoradiale est une direction perpendiculaire à un segment reliant le centre du cercle au point de mesure $Pm_i$ considéré et comprise dans le plan du cercle. Une direction radiale est une direction définie par une droite reliant le centre du cercle au point de mesure $Pm_i$.

Sur la figure 3, une direction radiale Dmr et une direction orthoradiale $Dm\vartheta$ ont été représentées pour chaque point de mesure $Pm_i$.

Selon l'exemple de la figure 3, chaque détecteur 27 configuré pour mesurer une composante de champ magnétique selon une direction orthoradiale $Dm\vartheta$ est associé à un point de mesure $Pm_i$ distinct des autres points de mesure $Pm_i$ associés à des composantes de champ magnétique selon des directions orthoradiales.

Par exemple, chaque détecteur 27 est configuré pour mesurer une valeur $Gm\vartheta$ d'une composante selon une direction orthoradiale $Dm\vartheta$ et une valeur Gmr d'une composante selon une direction radiale Dmr d'un champ magnétique en un unique point de mesure $Pm_i$.

Ainsi, chaque détecteur 27 est configuré pour mesurer deux valeurs Gm de composantes, selon deux directions différentes, en un unique point de mesure $Pm_i$.

Dans un système de coordonnées polaires, chaque coefficient de conversion est soit une fonction d'un sinus de l'angle φ0 soit une fonction d'un cosinus de l'angle φ0. Dans la suite, chaque coefficient de conversion dépendant d'un cosinus sera identifié par une référence $Ka_n$ et chaque coefficient de conversion dépendant d'un sinus sera identifié par une référence $Kb_n$.

Il est à noter que des fonctions d'un cosinus d'un nombre sont susceptibles d'être exprimées sous la forme d'un sinus d'une différence entre π/2 et ce nombre. De même, une fonction d'un sinus est susceptible d'être exprimée sous la forme d'un cosinus d'une différence entre π/2 et ce nombre. Il est entendu par « fonction d'un cosinus » une fonction dépendant d'un cosinus du nombre considéré et non d'une différence entre π/2 et ce nombre. Il est entendu par « fonction d'un sinus » une fonction dépendant d'un sinus du nombre considéré et non d'une différence entre π/2 et ce nombre.

Chaque coefficient de conversion $Ka_n$, $Kb_n$ est identifié par un indice n variant de 1 à l'ordre N.

De même, chaque composante $\alpha$ est soit une fonction d'un sinus de l'angle φ0 soit une fonction d'un cosinus de l'angle angle φ0. Dans la suite, chaque composante $\alpha$ dépendant d'un cosinus sera identifiée par une référence $a_n$ et chaque composante $\alpha$ dépendant d'un sinus sera identifiée par une référence $b_n$.

Chaque composante, $a_n$, $b_n$ est identifiée par un indice n variant de 1 à l'ordre N.

Chaque coefficient de conversion $Ka_n$, $Kb_n$ est conforme dans un cas théorique idéal à l'une des équations 2 et 3 ci-dessous :

$$U_n \cdot \frac{\cos(n\varphi 0)}{n(d0)^n} = Ka_n \qquad \text{(Equation 2)}$$

$$U_n \cdot \frac{\sin(n\varphi 0)}{n(d0)^n} = Kb_n \qquad \text{(Equation 3)}$$

dans lesquelles $U_n$ est une constante réelle arbitraire liée aux conditions pratiques de mise en oeuvre du capteur 20.

Selon le principe de la décomposition en harmoniques spatiales, les valeurs des composantes radiale Gmr et orthoradiale Gmϑ du champ magnétique Cm en un point de mesure $Pm_i$ sont alors susceptibles de s'écrire selon les équations 4 et 5 ci-dessous :

$$Gmr(r_i, \vartheta_i) = \sum_{n=1}^{\infty} n.r_i^{n-1} \left[ -a_n \sin(n\vartheta_i) + b_n \cos(n\vartheta_i) \right] \qquad \text{(Equation 4)}$$

$$Gm\vartheta(r_i, \vartheta_i) = \sum_{n=1}^{\infty} n.r_i^{n-1} \left[ a_n \cos(n\vartheta_i) + b_n \sin(n\vartheta_i) \right] \qquad \text{(Equation 5)}$$

dans lesquelles $a_n$ et $b_n$ sont des coefficients de la décomposition en harmoniques spatiales, $\Sigma$ est le signe d'une sommation, $\vartheta_i$ et $r_i$ sont les coordonnées polaires du point de mesure $Pm_i$ et le point de référence Pr, cos désigne la fonction cosinus et sin désigne la fonction sinus.

Chaque terme T est une fonction d'un cosinus de l'angle $\vartheta_i$ et/ ou d'un sinus de l'angle $\vartheta_i$.

Par exemple, la matrice M est conforme à l'équation :

$$M = \begin{pmatrix} \cos(\vartheta_1) & \sin(\vartheta_1) & ... & ... & Nr_i^{N-1}\cos(N\vartheta_1) & Nri^{N-1}\sin(N\vartheta_1) \\ -\sin(\vartheta_1) & \cos(\vartheta_1) & ... & ... & -Nr_i^{N-1}\sin(N\vartheta_1) & -Nri^{N-1}\cos(N\vartheta_1) \\ ... & ... & ... & ... & ... & ... \\ & ... & ... & ... ... & ... & ... \\ \cos(\vartheta_{N1}) & \sin(\vartheta_{N1}) & ... & ... & Nr_i^{N-1}\cos(N\vartheta_{N1}) & Nr_i^{N-1}\sin(N\vartheta_{N1}) \\ -\sin(\vartheta_{N1}) & \cos(\vartheta_{N1}) & ... & ... & -Nr_i^{N-1}\sin(N\vartheta_{N1}) & -Nr_i^{N-1}\cos(N\vartheta_{N1}) \end{pmatrix}$$

$$\text{(Equation 6)}$$

Lorsque la matrice M est conforme à l'équation 6, le vecteur B est, par exemple, égal à :

$$B = \begin{pmatrix} Gm\vartheta_1 \\ Gmr1 \\ ... \\ Gm\vartheta_{N-1} \\ Gmr_{N-1} \end{pmatrix} \quad \text{(Equation 7)}$$

Dans ce cas, l'équation 1 ci-dessus correspond à une troncature à l'ordre maximal N de la décomposition en harmoniques spatiales du champ magnétique mesuré. Il est alors possible de démontrer que les coefficients $a_n$ et $b_n$ des équations 4 et 5 précédentes sont conformes aux équations 8 et 9 ci-dessous lorsque le courant IA traversant le premier conducteur 15A est la seule source de champ présente :

$$a_n = U_n \cdot \frac{\cos(n\varphi 0)}{n(d0)^n} IA = Ka_n . IA \qquad \text{(Equation 8)}$$

$$b_n = U_n \cdot \frac{\sin(n\varphi 0)}{n(d0)^n} IA = Kb_n . IA \qquad \text{(Equation 9)}.$$

Les équations 8 et 9 ci-dessus permettent de calculer des valeurs supposées des coefficients $a_n$ et $b_n$, dans un cas théorique idéal où la constante $U_n$ est arbitrairement unitaire, les coordonnées cylindriques d0, $\varphi$0 par rapport au point de référence Pr et la position dans l'espace des points de mesure Pm$_i$ sont parfaitement connus. On constate alors que chaque coefficient $a_n$ ou $b_n$ est effectivement proportionnel au courant IA à déterminer. Le facteur de proportion est le coefficient de conversion Ka$_n$, Kb$_n$ correspondant.

Par souci de simplicité, les exemples précédents ont été décrits ci-dessus dans un cas où un unique capteur 20 est utilisé pour mesurer l'intensité IA d'un courant traversant un seul conducteur 15A.

Dans le cas où un deuxième conducteur 15B parcouru par le courant IB est présent, celui-ci contribue également au champ magnétique en chaque point de mesure Pmi de façon similaire au courant IA traversant le premier conducteur 15A. Ainsi, la contribution du courant IB traversant le deuxième conducteur 15B est conforme aux équations 4 et 5 ci-dessus, les contributions aux coefficients $a_n$ et $b_n$ étant calculés selon les équations 8 et 9 en remplaçant les coordonnées polaires (d0, $\varphi$0) du centre du premier conducteur 15A par les coordonnées polaires (db, ($\varphi$b) du centre du deuxième conducteur 15B. Cette contribution s'additionne linéairement à celle du premier conducteur 15A.

On constate que comme la distance db entre le point de référence Pr et le centre du deuxième conducteur 15B est supérieure strictement à la distance d0 entre le point de référence Pr et le centre du premier conducteur 15A, la contribution due au courant IB traversant le deuxième conducteur 15B dans le calcul des coefficients $a_n$ et $b_n$ est plus faible que pour le courant IA traversant le premier conducteur 15A. Cette différence est d'autant plus importante que l'ordre n considéré est grand.

Ainsi, pour un indice n assez grand, la contribution du courant IB est suffisamment faible pour considérer avec une bonne précision que les coefficients $a_n$ et $b_n$ sont uniquement proportionnels au courant IA traversant le premier conducteur 15A, même si le courant IB traversant le deuxième conducteur est non nul. Cela est également vrai même pour toutes les autres sources extérieures qui seraient plus éloignées du point de référence Pr que les conducteurs 15A, 15B.

Ainsi, en sélectionnant les ordres les plus élevés, les contributions des sources sont alors filtrées spatialement, pour ne conserver que les contributions dues à la source la plus proche, à savoir ici le courant IA du premier conducteur 15A.

Il est à noter que pour des raisons de contrainte de mise en oeuvre pratique, par exemple, si l'ordre maximum N est trop faible pour pleinement décrire le champ magnétique ou si le nombre de mesures Nv effectuées est insuffisant, la constante $U_n$ présente dans les équations 8 et 9 peut s'éloigner de la valeur unité. Cependant, les coefficients $\alpha$ restent linéairement dépendants de l'intensité IA par exemple si seul le conducteur 15A est étudié. Ainsi, il reste possible d'obtenir avec une bonne précision la valeur de l'intensité IA.

Une procédure de calibration permettant d'obtenir une valeur précise des coefficients de conversion K est décrite ultérieurement.

Selon une variante, le capteur 20 fait partie d'un système de mesure comportant une pluralité de capteurs 20 et un unique contrôleur central.

Le calculateur 30 de chaque capteur 20 est configuré pour communiquer avec le contrôleur central. Par exemple, chaque capteur 20 est connecté au contrôleur central par une liaison filaire.

En variante, chaque capteur 20 est configuré pour communiquer avec le contrôleur central par communication radiofréquence.

Cela signifie que le calculateur 30 est propre à émettre ou à recevoir des données transmises via un signal comportant au moins une onde électromagnétique radiofréquence. Les ondes électromagnétiques radiofréquences sont les ondes électromagnétiques présentant une fréquence entre 3 kilohertz (KHz) et 3 gigahertz (GHz).

Le calculateur 30 de chaque capteur 20 est configuré pour transmettre au contrôleur central les valeurs des intensités IA, IB mesurées. Le contrôleur central est configuré pour mémoriser les valeurs des intensités IA, IB mesurées. Le contrôleur central est, en outre, configuré pour afficher ou transmettre les valeurs des intensités IA, IB mesurées à destination d'un utilisateur.

Selon une autre variante, les valeurs Gmr, Gmϑ mesurées en chaque point de mesure Pmi sont transmises au contrôleur central, qui met en oeuvre les étapes d'obtention 110, de formation 120, de calcul 130 et de détermination 140 pour chaque capteur 20.

Selon un mode de réalisation particulier, le capteur 20 est obtenu par un procédé de conception utilisant le procédé de mesure ci-dessus.

En particulier, le nombre de valeurs Nv, et donc le nombre de détecteurs 27, sont déterminés, par le procédé de conception, en fonction d'une précision de mesure souhaitée.

Le positionnement spatial des détecteurs 27 est également déterminé en utilisant le procédé de mesure. En particulier, le positionnement spatial des détecteurs 27 est choisi de manière à simplifier les calculs effectués lors des étapes 120 de formation, 130 de calcul et une 140 de détermination.

Par exemple, l'orientation de chaque détecteur 27 est choisie de manière à ce que les valeurs Gmr, Gmϑ de champ magnétique mesurées soient aisément transposables dans un système de coordonnées choisi.

Selon un mode de réalisation, l'ordre maximum est inférieur ou égal à 5 pour une distance d0 inférieure ou égale à 10 cm. En pratique, un ordre maximum N égal à 4, et une distance d0 égale à 6 centimètres entre le centre du cercle sur lequel sont disposés les points de mesure Pmi et le centre du premier conducteur 15A, permettent d'obtenir une précision en général inférieure à 0,5% lorsque le rayon $r_i$ du cercle est égal à 3,2 cm, même en cas de forte perturbation.

Le deuxième exemple ci-dessus a été donné dans le cas où le champ magnétique est décrit de manière simple dans un système de coordonnées polaires. C'est en particulier le cas de conducteurs 15A, 15B rectilignes, pour lesquels on peut considérer que le champ magnétique Cm généré par les conducteurs 15A, 15B ne varie pas en fonction de la position selon la direction principale Z. Ainsi, toutes les composantes de champ magnétique Cm mesurées sont comprises dans un même plan, qui est le plan du cercle sur lequel sont agencés les points de mesure $Pm_i$. L'ensemble 25 de détecteurs est alors aisé à réaliser.

En outre, les calculs effectués lors de la mise en oeuvre du procédé de mesure sont relativement simples. Le procédé de mesure est alors peu gourmand en termes de ressources de calcul.

Cependant, il est à noter que d'autres systèmes de coordonnées sont susceptibles d'être utilisés pour des géométries de conducteurs différentes, en utilisant une base de fonctions adaptée aux systèmes de coordonnées utilisés pour les équations 1 à 9 ci-dessus.

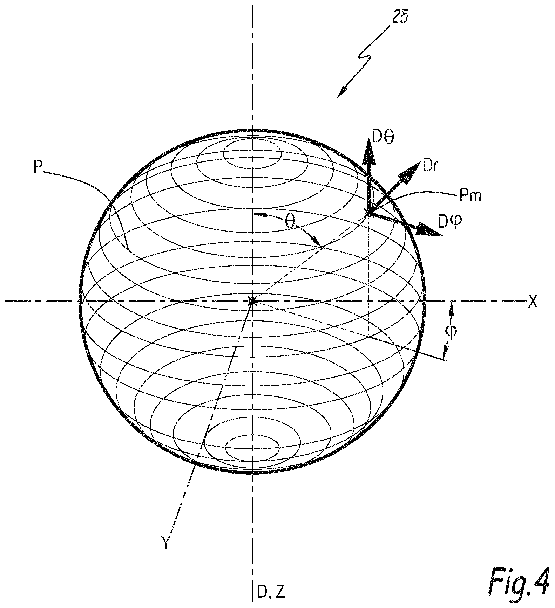

Par exemple, un troisième exemple de capteur 20 a été représenté sur la figure 4. Les éléments identiques au deuxième exemple de la figure 3 ne sont pas décrits à nouveau. Seules les différences sont mises en évidence.

Les points de mesure $Pm_i$ sont agencés sur une sphère dont le centre est le point de référence Pr. Par exemple, les points de mesure $Pm_i$ sont répartis sur un ensemble de parallèles P de la sphère.

Selon un mode de réalisation, l'ensemble 25 comporte 30 détecteurs 27 répartis sur 5 parallèles P. Par exemple, six points de mesure $Pm_i$ sont agencés sur chaque parallèle P. Les points de mesure $Pm_i$ agencés le long d'un même parallèle P sont, par exemple, équirépartis le long du parallèle P.

Chaque parallèle P est un cercle inscrit dans la sphère, les centres des parallèles P étant alignés sur une droite D passant par le centre de la sphère. Chaque parallèle P est défini par l'intersection d'un plan et de la sphère, les plans étant parallèles les uns aux autres et décalés les uns par rapport aux autres selon la direction de la droite D. La droite D est, par exemple, parallèle avec la direction principale Z.

Chaque détecteur 27 est configuré pour mesurer des valeurs Gm de composantes de champ magnétique en un même point de mesure $Pm_i$ selon trois directions de mesure Dm différentes.

Les directions de mesure Dm sont chacune parallèle à un vecteur de base d'un repère de coordonnées sphériques associé au point $Pm_i$ considéré. Dans le repère sphérique, les coordonnées spatiales de chaque point de mesure $Pm_i$ sont le rayon $r_i$ et deux angles $\varphi_i$ et $\theta_i$. Le rayon $r_i$ est la distance entre le point de mesure Pmi et le point de référence Pr. L'angle $\theta_i$ est un angle entre la direction principale Z et un segment reliant le point de mesure $Pm_i$ au point de référence Pr. L'angle $\varphi_i$ est un angle entre la direction X et la projection de ce même segment sur un plan perpendiculaire à la direction principale Z.

Afin d'assurer la lisibilité de la figure 4, un seul point de mesure Pm y est représenté, avec les directions de mesure Dm et les coordonnées associées. Les indices i des références associées n'y sont donc pas représentés.

Les trois directions de mesure Dm sont, par exemple deux directions tangentielles Dφ, Dθ et une direction radiale Dr.

Chaque direction tangentielle Dφ, Dθ est une direction tangente à la sphère en le point de mesure $Pm_i$ correspondant. La direction tangentielle Dφ est perpendiculaire à un plan contenant la direction principale Z et un segment reliant le point de mesure $Pm_i$ correspondant au point de référence Pr. Chaque direction radiale Dr est une direction parallèle au segment reliant le point de mesure $Pm_i$ correspondant au point de référence Pr. La direction tangentielle Dθ est perpendiculaire à la direction tangentielle Dφ et à la direction radiale Dr.

Le troisième exemple de capteur 20 est alors adapté à des cas où les conducteurs 15A, 15B ne sont pas rectilignes et où le champ magnétique Cm présente donc des composantes significatives dans les trois directions de mesure Dm.

Du fait que le champ magnétique Cm est tridimensionnel, les fonctions élémentaires pour le calcul de M sont plus complexes mais ce troisième exemple est adaptable à un plus grand nombre de configurations des conducteurs 15A, 15B.

Le champ magnétique Cm est alors conforme à l'équation :

$$Cm(r_i, \theta_i, \varphi_i) = -\sum_{n=1}^{N} \sum_{m=-n}^{n} \alpha_{n,m} \nabla_{r_i, \theta_i, \varphi_i} \left[ r_i^n Y_n^m(\theta_i, \varphi_i) \right] \quad \text{(Equation 10)}$$

dans laquelle :

- $\nabla$ est l'opérateur différentiel Nabla,
- $\alpha_{n,m}$ est un coefficient de la décomposition en harmoniques spatiales dans le système de coordonnées sphériques et
- $Y_n^m$ sont des fonctions harmoniques sphériques.

Il est à noter que, pour un ordre maximum N donné, un plus grand nombre N2 de termes T sont calculés par rapport au deuxième exemple précédent et un plus grand nombre de valeurs Gm du champ magnétique sont mesurées.

Selon un quatrième exemple, chaque courant est un courant variable. Par exemple, chaque courant est une phase d'un courant triphasé.

Les étapes 120 de formation, 130 de calcul et 140 de détermination sont alors itérées dans cet ordre avec une période d'itération prédéterminée. La période d'itération correspond à une fréquence d'échantillonnage des valeurs Gm du champ magnétique.

De préférence, les étapes 120 de formation, 130 de calcul et 140 de détermination sont itérées sur une durée temporelle correspondant à plusieurs périodes du courant.

Une transformation de Fourier est ensuite appliquée aux valeurs d'intensité IA mesurées pour obtenir une valeur efficace de l'intensité IA. La transformation de Fourier est, par exemple, obtenue avec un algorithme de transformation de Fourier rapide (également appelé FFT, de l'anglais « Fast Fourier Transform » qui signifie « transformation de Fourier rapide »).

La transformation de Fourier est, par exemple, une transformation de Fourier temporelle, c'est-à-dire en fonction du temps.

En variante, au cours de chaque étape de formation 120, une transformation de Fourier est appliquée à un ensemble de vecteurs de mesure B obtenus au cours de l'étape de formation 120 et d'une pluralité d'étapes de formation 120 antérieures pour calculer une transformée de Fourier TB du vecteur de mesure B.

L'étape 130 de calcul est alors mise en oeuvre avec la transformée de Fourier TB au lieu du vecteur de mesure B, pour obtenir une transformée de Fourier du vecteur de coefficients A.

Selon un cinquième exemple, l'étape de calibration 100 comprend une étape 150 d'optimisation et une étape 160 de calcul d'un coefficient de conversion $Ka_n$, $Kb_n$.

Il est à noter que dans les équations 1 à 10 ci-dessus, un certain nombre de paramètres du capteur 20 sont utilisés, tels que des coordonnées spatiales. Ces paramètres sont susceptibles de varier en fonction de la fabrication du capteur 20 ou au cours de la vie de celui-ci, par exemple à la suite de chocs ou en cas de mauvais positionnement de l'ensemble 25 par rapport au premier conducteur 15A, ou du vieillissement de matériaux.

Au cours de l'étape d'optimisation 150, des paramètres du capteur 20 sont optimisés pour améliorer la précision des calculs ultérieurs. Les paramètres optimisés sont, en particulier, des paramètres géométriques du capteur 20. En particulier, une position réelle du centre du premier conducteur 15A par rapport au point de référence Pr est obtenue.

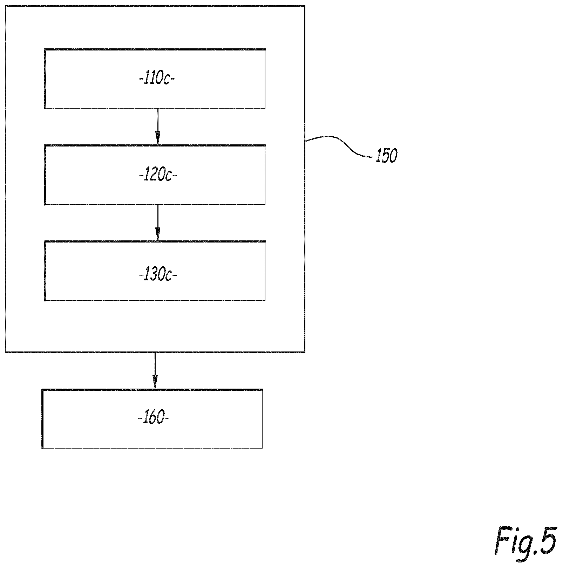

Au cours de l'étape d'optimisation 150, l'étape 110 d'obtention d'une matrice, l'étape 120 de formation et l'étape 130 de calcul sont mises en oeuvre pour une valeur quelconque de l'intensité IA. Cela est représenté sur la figure 5 par des étapes 110c, 120c et 130c.

Selon un mode de mise en oeuvre, l'étape d'optimisation 150 est mise en oeuvre pour une valeur de l'intensité IA suffisamment élevée pour s'affranchir d'un éventuel bruit magnétique.

Par exemple, la position réelle du centre du premier conducteur 15A par rapport au point de référence Pr est obtenue par minimisation d'un écart pour une pluralité de positions courantes Pc.

Plus précisément, un ensemble de coefficients $\alpha$ est calculé pour un ensemble de positions du centre du premier conducteur 15A par rapport au point de référence Pr, appelées positions courantes Pc. Chaque position courante Pc est une position dans laquelle est susceptible de se trouver par rapport au point de référence Pr, suite à un mauvais placement ou à une imprécision dans la construction du capteur 20, ou encore suite à une modification de la géométrie du capteur 20 ultérieure à la fabrication de celui-ci, par exemple à cause d'un choc ou d'une usure, le centre du premier conducteur 15A.

Chaque position courante Pc est, par exemple, choisie dans une gamme de positions prédéterminée.

Dans le cas où la position supposée du centre du premier conducteur 15A par rapport au point de référence Pr est définie, dans un système de coordonnées cylindriques, par une distance d0 et par un angle $\varphi 0$, chaque position courante Pc est, par exemple, une paire d'un angle courant cpc et d'une distance courante dc.

Un ensemble de coefficients appelés coefficients intermédiaires $\alpha_i$ est alors calculé, au cours de l'étape d'optimisation 150 pour chaque jeu de paramètres.

Au cours de l'étape 110c d'obtention, la matrice M est calculée pour chaque position courante Pc.

Lors de l'étape 120c de formation le vecteur B est calculé par la loi de Biot et Savart et non plus mesuré en fonction de l'intensité IA du courant.

Au cours de l'étape 130c, les coefficients intermédiaires $\alpha_i$ sont calculés selon l'équation 1, en utilisant la matrice M et le vecteur B calculés au cours des étapes 110c et 120c.

Par exemple, une paire de coefficients intermédiaires $\alpha_i$ est calculée pour chaque position courante Pc.

Le nombre de positions courantes Pc utilisées est déterminé en fonction de la configuration du ou des conducteurs 15A, 15B, du mode de fixation de l'ensemble 25 au premier conducteur 15A et de la précision souhaitée pour la mesure de l'intensité IA.

Par exemple, les positions courantes Pc correspondent à des distances d0 entre le point de référence Pr et le centre du premier conducteur 15A comprises entre 5 cm et 50 cm. Selon un mode de mise en oeuvre particulier, l'ensemble des distances d0 correspondant aux positions courantes Pc couvre la gamme entre 5 cm et 15 cm avec un pas de 1 millimètre (mm).

L'ensemble des angles $\varphi 0$ entre la direction X et un segment reliant le point de référence Pr au centre du premier conducteur 15A couvre, par exemple, la gamme entre 175° et 185°, avec un pas de 0,5°.

Selon un mode de réalisation, un ensemble de rapports intermédiaires $R_\alpha$ entre des coefficients intermédiaires $\alpha_i$ est calculé.

Chaque rapport intermédiaire $R_\alpha$ est calculé par la division d'un numérateur par un dénominateur, le numérateur étant un coefficient intermédiaire $\alpha_i$ calculé en supposant une position courante Pc et pour une valeur donnée de l'indice n et le dénominateur étant un autre coefficient intermédiaire $\alpha_i$ calculé pour la même position courante Pc. Par exemple, le dénominateur et le numérateur correspondent à des valeurs différentes de l'indice n. En variante, le dénominateur et le numérateur peuvent également correspondre à des valeurs identiques de l'indice n.

Par exemple, chaque rapport intermédiaire $R_\alpha$ est obtenu par la division de coefficients intermédiaires $\alpha_i$ calculés pour des valeurs de l'indice n dont la différence est égale à 1.

Lorsque deux coefficients intermédiaires $\alpha_i$, notés $a_{cn}$ par la suite, sont conformes à l'équation 8 précédente, le rapport intermédiaire $R_\alpha$ correspondant est identifié par une référence $Rca_n$, en l'absence de source de champ magnétique autre que le premier conducteur 15A, est alors conforme à l'équation:

$$Rca_n = \frac{ac_{n+1}}{ac_n} = \frac{U_{n+1}}{U_n} \frac{1}{dc} \frac{n}{(n+1)} \frac{\cos((n+1) \cdot \varphi c)}{\cos(n \cdot \varphi c)} \qquad \text{(Equation 11)}$$

On note que, même en présence d'autres sources de champ magnétique que le conducteur 15A par exemple, l'équation 11 reste valide à partir d'un ordre N suffisamment grand pour pouvoir négliger l'influence de ces autres sources, en fonction du niveau de précision souhaité.

Selon une autre variante, au moins un rapport intermédiaire $R_\alpha$, identifié par une référence $Rcc_n$, est calculé à partir d'un coefficient intermédiaire, notés $a_{cn}$, conforme à l'équation 8 précédente et un coefficient intermédiaire, notés $b_{cn}$, conforme à l'équation 9 précédente.

Selon un mode de réalisation, pour chaque position courante Pc, un rapport courant $R_\alpha$ est calculé pour chaque valeur de l'indice n allant de 1 à N.

En outre, pour chaque valeur de l'indice n allant de 1 à N, un rapport réel $Rra_n$ entre deux composantes du vecteur de coefficient A est calculé selon l'équation :

$$Rra_n = \frac{a_{n+1}}{a_n} \qquad \text{(Equation 12)}$$

De même, pour chaque valeur de l'indice n allant de 1 à N, un rapport réel $Rrc_n$ entre deux composantes du vecteur de coefficient A est calculé selon l'équation :

$$Rrc_n = \frac{b_{n+1}}{a_n} \qquad \text{(Equation 13)}$$

La position réelle est alors obtenue par optimisation de la position courante Pc par minimisation de l'écart entre un rapport réel Rr et un rapport courant Rc correspondant.

Par exemple, des valeurs absolues d'un ensemble d'écarts entre des rapports réels $Rra_n$, $Rrc_n$ et des rapports intermédiaires $Rca_n$, $Rcc_n$ sont minimisées.

Selon un mode de réalisation, la minimisation porte sur la somme d'un ensemble de valeurs absolues d'écarts entre des rapports réels Rr et les rapports intermédiaires Rc correspondants.

Selon un mode de réalisation, la minimisation est définie par l'expression mathématique :

$$\min_{Pc} \sum_{n=1}^{N-1} \left\| \frac{a_{n+1}}{a_n} - Rca_n \right\| + \left\| \frac{b_{n+1}}{a_n} - Rcc_n \right\| \qquad \text{(Equation 14)}$$

Ainsi, la position réelle est la position courante Pc pour laquelle l'expression mathématique de l'équation 14 est la plus petite.

L'étape d'optimisation 150 ci-dessus a été décrite dans le cas de l'optimisation de la position du centre du premier conducteur 15A par rapport au point de référence Pr. Il est à noter que d'autres paramètres du capteur 20 sont susceptibles d'être ainsi optimisés. Par exemple, des coordonnées spatiales, $\vartheta_i$ et $r_i$ d'un point de mesure $Pm_i$ sont susceptibles d'être ainsi optimisées. Les positions courantes Pc sont alors des positions que le point de mesure $Pm_i$ considéré est susceptible d'occuper.

De manière générale, le jeu de paramètres optimisés est le jeu de paramètres qui est conforme à l'expression mathématique de l'équation 14.

Ainsi, à l'issue de l'étape 150 d'optimisation, un jeu de paramètres optimisés est obtenu.

Lors de l'étape 160 de calcul d'un coefficient de conversion, un coefficient de conversion K est calculé en divisant le coefficient $\alpha$ correspondant obtenu avec le jeu de paramètres, par l'intensité IA utilisée lors de la calibration.

Au cours de l'étape 140 de détermination, l'intensité IA est calculée à partir d'un coefficient $\alpha$ obtenu à l'étape de calcul 130 et du coefficient de conversion K correspondant calculé lors de l'étape de calibration 100.

Le procédé de mesure est alors plus précis, car les coefficients de conversion K sont déterminés sur site et en conditions réelles, avec précision au lieu d'être supposés connus. Le procédé de mesure est donc moins sensible à d'éventuelles erreurs de placement de l'ensemble 25 de détecteurs 27 par rapport au premier conducteur 15A.

En outre, l'étape de calibration est effectuée à partir de rapports entre des coefficients $a_n$, $b_n$. De tels rapports ne dépendent pas de la valeur de l'intensité IA circulant dans le premier conducteur 15A. La calibration est donc susceptible d'être effectuée à n'importe quel moment, car elle ne suppose pas de fixer l'intensité IA à une valeur prédéterminée. En d'autres termes, l'étape de calibration 100, elle aussi, ne perturbe pas le fonctionnement du réseau 10.

L'étape de calibration 110 a été décrite pour le cinquième exemple ci-dessus dans un cas où le champ magnétique Cm est bidimensionnel, correspondant par exemple à la configuration du deuxième exemple. Il est à noter que cette étape de calibration est susceptible d'être mise en oeuvre pour d'autres configurations moyennant une adaptation correspondante des équations 11 à 13.

Selon une variante de l'étape de calibration 110, l'intensité du courant circulant dans le premier conducteur 15A est connue, et le ou les coefficients de conversion $Ka_n$, $Kb_n$ sont calculés selon l'une des équations 8 et 9 ci-dessus.

L'invention n'est pas limitée aux modes de réalisations précédemment décrits et s'étend à tous les modes de réalisation couverts par les revendications.

**Revendications**

**1.** Procédé de mesure de l'intensité (IA) d'un courant dans un conducteur électrique (15A) sur la base de mesures de valeurs de composantes ($b_i$) d'un champ magnétique reçues depuis un ensemble (25) de détecteurs (27) positionnés relativement au conducteur électrique (15A), la position de chaque détecteur étant connue relativement à un point de référence (Pr) de sorte que les distances ($r_i$) entre ce dernier et les points de mesure ($Pm_i$) que constituent les détecteurs (27) sont déterminées, le procédé comprenant les étapes de :

- obtention (110) d'une matrice de calcul M comprenant un ensemble de termes (T) répartis en un nombre fini de lignes et un nombre fini de colonnes,

ladite matrice de calcul M étant obtenue (110) en fonction des coordonnées de points de mesure ($Pm_i$) par rapport au point de référence (Pr),
le positionnement de l'ensemble (25) de détecteurs relativement au conducteur électrique (15A) étant tel que, avec une première distance (d1) définie entre le point de référence (Pr) et le point du conducteur (15A) le plus proche du point de référence (Pr), le maximum des distances ($r_i$) des points de mesure ($Pm_i$) relativement au point de référence (Pr) est strictement inférieur à la première distance (d1), et les points de mesure ($Pm_i$) étant agencés le long d'un cercle de centre le point de référence (Pr) ou d'une sphère de centre le point de référence (Pr),
chaque terme (T) d'une même ligne de la matrice de calcul (M) étant proportionnel à la même distance (ri) entre un point de mesure ($Pm_i$) et le point de référence (Pr), élevée à une puissance supérieure ou égale à zéro, chaque colonne de la matrice de calcul (M) étant élevée à une puissance différente des autres colonnes,

- formation (120) d'un vecteur de mesure B comportant les mesures de valeurs de composantes ($b_l$) reçues depuis ledit ensemble (25) de détecteurs (27), chaque composante ($b_l$) étant prise selon une direction (Dmr, Dm$\vartheta$, D$\theta$, D$\varphi$, Dr) en un point de mesure ($Pm_i$), chaque point de mesure ($Pm_i$) associé à une direction (Dmr, Dm$\vartheta$, D$\theta$, D$\varphi$, Dr) étant distinct des autres points de mesure ($Pm_i$) associés à la même direction (Dmr, Dm$\vartheta$, D$\theta$, D$\varphi$, Dr),
- calcul (130) de composantes ($\alpha$) d'un vecteur de coefficients A, le vecteur A comprenant autant de composantes ($\alpha$) que la matrice M comprend de colonnes et vérifiant la relation matricielle B = M x A, x dénotant l'opération de multiplication matricielle, de sorte que chaque composante ($\alpha$) calculée corresponde à un coefficient d'une décomposition du champ magnétique en harmoniques spatiales et soit proportionnel à l'intensité (IA) du courant dans le conducteur électrique (15A), et
- détermination (140) de l'intensité (IA) du courant dans le conducteur électrique (15A) à partir au moins des composantes ($\alpha$) calculées.

2. Procédé selon la revendication 1, dans lequel les étapes d'obtention (110) d'une matrice de calcul (M) et de calcul (130) sont fonction de paramètres du capteur (20), le procédé comprenant, en outre :

- une étape d'optimisation (150) comprenant l'obtention d'au moins un paramètre optimisé, tels que la position réelle du point de référence (Pr) par rapport au conducteur électrique (15A),
- une étape de calcul (160) d'au moins un coefficient de conversion (K) à partir du ou des paramètres optimisés,
- l'étape de détermination (140) comprenant la mise en oeuvre de la division d'une valeur réelle d'un coefficient ($\alpha$) par le coefficient de conversion (K).

3. Procédé selon la revendication 2, dans lequel l'étape d'obtention (160) est mise en oeuvre par recherche d'un jeu de paramètres optimisés minimisant l'écart entre au moins deux rapports entre deux composantes ($\alpha$) du vecteur de coefficients (A) obtenu lors de l'étape (130) de calcul des composantes ($\alpha$) et deux rapports entre deux composantes intermédiaires ($\alpha_i$), chaque composante intermédiaire ($\alpha_i$) étant une composante d'un vecteur de coefficients (A) calculé pour un jeu de paramètres possibles du capteur (20).

4. Procédé selon l'une quelconque des revendications 1 à 3, dans lequel une première distance (d1) est définie entre le point de référence (Pr) et le point du conducteur (15A) le plus proche du point de référence (Pr), le maximum des distances des points de mesure ($Pm_i$) étant inférieur ou égal à 85% de la première distance (d1).

5. Procédé selon l'une quelconque des revendications 1 à 4, dans lequel une première distance (d1) est définie entre le point de référence (Pr) et le point du conducteur (15A) le plus proche du point de référence (Pr), la première distance (d1) étant inférieure ou égale à 10 centimètres et chaque puissance étant inférieure ou égale à 5.

6. Procédé de conception d'un capteur de mesure comportant une pluralité de détecteurs (27) de champ magnétique, le procédé de conception déterminant, pour une précision de mesure souhaitée, le nombre de détecteurs (27) de champ magnétique, ainsi que le positionnement spatial des détecteurs (27), en utilisant le procédé de mesure selon l'une quelconque des revendications 1 à 5.

7. Calculateur (30) pour mesurer l'intensité (IA) d'un courant dans un conducteur électrique (15A) sur la base de mesures de valeurs de composantes ($b_l$) d'un champ magnétique reçues depuis un ensemble (25) de détecteurs (27) positionnés relativement au conducteur électrique (15A), la position de chaque détecteur étant connue relativement à un point de référence (Pr) de sorte que les distances ($r_i$) entre ce dernier et les points de mesure ($Pm_i$) que constituent les détecteurs (27) sont déterminées, le calculateur étant **caractérisé en ce qu'**il est adapté pour mettre en oeuvre les étapes suivantes :

  - obtention (110) d'une matrice de calcul M comprenant un ensemble de termes, répartis en un nombre fini de lignes et un nombre fini de colonnes,

    ladite matrice de calcul M étant obtenue (110) en fonction des coordonnées de points de mesure ($Pm_i$) par rapport au point de référence (Pr),
    le positionnement de l'ensemble (25) de détecteurs (27) relativement au conducteur électrique (15A) étant tel que, avec une première distance (d1) définie entre le point de référence (Pr) et le point du conducteur (15A) le plus proche du point de référence (Pr), le maximum des distances ($r_i$) des points de mesure ($Pm_i$) relativement au point de référence (Pr) est strictement inférieur à la première distance (d1), et les points de mesure ($Pm_i$) étant agencés le long d'un cercle de centre le point de référence (Pr) ou d'une sphère de centre le point de référence (Pr),
    chaque terme d'une même ligne de la matrice de calcul (M) étant proportionnel à la même distance ($r_i$) entre le point de mesure ($Pm_i$) et le point de référence (Pr), élevée à une puissance supérieure ou égale à zéro,
    chaque colonne de la matrice de calcul (M) étant élevée à une puissance différente des autres colonnes,

  - réception de mesures de valeurs de composantes ($b_l$) du champ magnétique depuis ledit ensemble (25) de détecteurs (27), chaque composante ($b_l$) étant prise selon une direction (Dmr, Dmϑ, Dθ, Dφ, Dr) en un point de mesure (Pm;), chaque point de mesure ($Pm_i$) associé à une direction (Dmr, Dmϑ, Dθ, Dφ, Dr) étant distinct des autres points de mesure ($Pm_i$) associés à la même direction (Dmr, Dmϑ, Dθ, Dφ, Dr),
  - formation (120) d'un vecteur de mesure B comportant les mesures de valeurs de composantes ($b_l$) reçues,
  - calcul (130) de composantes ($\alpha$) d'un vecteur de coefficients A, le vecteur A comprenant autant de composantes ($\alpha$) que la matrice M comprend de colonnes et vérifiant la relation matricielle B = M x A, x dénotant l'opération de multiplication matricielle, de sorte que chaque composante ($\alpha$) calculée corresponde à un coefficient d'une décomposition du champ magnétique en harmoniques spatiales et soit proportionnel à l'intensité (IA) du courant dans le conducteur électrique (15A), et
  - détermination (140) de l'intensité (IA) du courant dans le conducteur électrique (15A) à partir au moins des composantes calculées.

8. Capteur de courant (20) configuré pour mesurer une intensité (IA) d'un courant traversant un conducteur électrique (15A), le capteur de courant (20) comprenant une pluralité de détecteurs de champ magnétique (27) et un calculateur (30) selon la revendication 7, chaque détecteur (27) étant configuré pour mesurer la valeur du champ magnétique selon une direction (Dmr, Dmϑ, Dθ, Dφ, Dr) en un point de mesure (Pm;), chaque point de mesure ($Pm_i$) étant distinct et à une distance ($r_i$) d'un point de référence (Pr), et pour transmettre la valeur mesurée au calculateur (30).

9. Système de mesure de courants (IA, IB) traversant une pluralité de conducteurs électriques (15A, 15B), le système de mesure comprenant une pluralité de capteurs de courant (20) selon la revendication 8 et un unique contrôleur central, chaque capteur (20) étant configuré pour communiquer avec le contrôleur central.


**Patentansprüche**

1. Verfahren zum Messen der Intensität (IA) eines Stromes in einem elektrischen Leiter (15A) auf Basis von Messungen von Komponentenwerten ($b_l$) eines Magnetfelds, die von einer Reihe (25) von Detektoren (27) empfangen werden, die in Bezug zum elektrischen Leiter (15A) positioniert sind, wobei die Position jedes Detektors in Bezug zu einem Referenzpunkt (Pr) bekannt ist, sodass die Abstände (r;) zwischen diesem letzteren und den Messpunkten ($Pm_i$) welche die Detektoren (27) darstellen, bestimmt werden, wobei das Verfahren die Schritte umfasst zum:

  - Erhalten (110) einer Berechnungsmatrix M, die eine Reihe von Begriffen (T) umfasst, die in eine endliche Anzahl von Zeilen und eine endliche Anzahl von Spalten aufgeteilt sind,
    wobei die Berechnungsmatrix M (110) in Abhängigkeit von den Koordinaten von Messpunkten ($Pm_i$) in Bezug auf den Referenzpunkt (Pr) erhalten wird,
    die Positionierung der Reihe (25) von Detektoren in Bezug auf den elektrischen Leiter (15A) so ist, dass bei einem ersten Abstand (d1), der zwischen dem Referenzpunkt (Pr) und dem Punkt des Leiters (15A) definiert ist, der dem Referenzpunkt (Pr) am nächsten liegt, das Maximum der Abstände ($r_i$) der Messpunkte ($Pm_i$) in Bezug auf den Referenzpunkt (Pr) streng kleiner ist als der erste Abstand (d1), und die Messpunkte ($Pm_i$) entlang eines Kreises mit dem Referenzpunkt (Pr) als Mittelpunkt oder einer Kugel mit dem Referenzpunkt (Pr) als Mittelpunkt angeordnet sind, wobei jeder Begriff (T) einer gleichen Zeile der Berechnungsmatrix (M) proportional zum gleichen Abstand ($r_i$) zwischen einem Messpunkt ($Pm_i$) und dem Referenzpunkt (Pr) ist, der mit einer Leistung größer oder gleich Null angehoben ist, wobei jede Spalte der Berechnungsmatrix (M) mit einer Leistung angehoben, die sich von den anderen Spalten unterscheidet,

- Bilden (120) eines Messvektors B, der die Messungen von Komponentenwerten ($b_l$) beinhaltet, die von der Reihe (25) von Detektoren (27) empfangen werden, wobei jede Komponente ($b_l$) in einer Richtung (Dmr, $Dm\theta$, $D\theta$, D(p, Dr) an einem Messpunkt ($Pm_i$) genommen wird, wobei jeder Messpunkt ($Pm_i$), der einer Richtung (Dmr, $Dm\theta$, $D\theta$, D(p, Dr) zugeordnet ist, sich von den anderen Messpunkten ($Pm_i$), die derselben Richtung (Dmr, $Dm\theta$, $D\theta$, D(p, Dr) zugeordnet sind, unterscheidet,
- Berechnen (130) von Komponenten ($\alpha$) eines Koeffizientenvektors A, wobei der Vektor A so viele Komponenten ($\alpha$) umfasst, wie die Matrix M Spalten umfasst und die Matrixbeziehung B = M x A überprüft, wobei x die Matrixmultiplikationsoperation angibt, sodass jede berechnete Komponente ($\alpha$) einem Koeffizienten einer Zerlegung des Magnetfelds in räumliche Oberschwingungen entspricht und proportional zur Intensität (IA) des Stromes im elektrischen Leiter (15A) ist, und
- Bestimmen (140) der Intensität (IA) des Stromes im elektrischen Leiter (15A) aus mindestens den berechneten Komponenten ($\alpha$).

2. Verfahren nach Anspruch 1, wobei die Schritte zum Erhalten (110) einer Berechnungsmatrix (M) und einer Berechnung (130) von Parametern des Sensors (20) abhängig sind, wobei das Verfahren weiter umfasst:

- einen Optimierungsschritt (150), der den Erhalt mindestens eines optimierten Parameters, wie der Ist-Position des Referenzpunkts (Pr) in Bezug auf den elektrischen Leiter(15A) umfasst,
- einen Berechnungsschritt (160) von mindestens einem Umwandlungskoeffizienten (K) aus dem oder den optimierten Parametern,
- den Bestimmungsschritt (140), der die Umsetzung der Division eines IstWertes eines Koeffizienten ($\alpha$) durch den Umwandlungskoeffizienten (K) umfasst.

3. Verfahren nach Anspruch 2, wobei der Schritt des Erhaltens (160) durch Suche nach einem optimierten Parametersatz durchgeführt wird, der die Abweichung zwischen mindestens zwei Verhältnissen zwischen zwei Komponenten ($\alpha$) des Koeffizientenvektors (A), der beim Schritt (130) zum Berechnen der Komponenten ($\alpha$) erhalten wird, und zwei Verhältnissen zwischen zwei Zwischenkomponenten ($\alpha_i$) minimiert, wobei jede Zwischenkomponente ($\alpha_i$) eine Komponente eines Koeffizientenvektors (A) ist, die für einen Satz möglicher Parameter des Sensors (20) berechnet wird.

4. Verfahren nach einem der Ansprüche 1 bis 3, wobei ein erster Abstand (d1) zwischen dem Referenzpunkt (Pr) und dem Punkt des Leiters (15A), der dem Referenzpunkt (Pr) am nächsten liegt, definiert ist, wobei das Maximum der Abstände der Messpunkte ($Pm_i$) kleiner oder gleich 85% des ersten Abstands (d1) ist.

5. Verfahren nach einem der Ansprüche 1 bis 4, wobei ein erster Abstand (d1) zwischen dem Referenzpunkt (Pr) und dem Punkt des Leiters (15A), der dem Referenzpunkt (Pr) am nächsten liegt, definiert ist, wobei der erste Abstand (d1) kleiner oder gleich 10 Zentimeter ist und jede Leistung kleiner oder gleich 5 ist.

6. Verfahren zum Gestalten eines Messsensors, der eine Vielzahl von Magnetfelddetektoren (27) beinhaltet, wobei das Verfahren zum Gestalten für eine gewünschte Messgenauigkeit die Anzahl der Magnetfelddetektoren (27), sowie die räumliche Positionierung der Detektoren (27) unter Verwendung des Messverfahrens nach einem der Ansprüche 1 bis 5 bestimmt.

7. Rechner (30) zum Messen der Intensität (IA) eines Stromes in einem elektrischen Leiter (15A) auf Basis von Messungen von Komponentenwerten ($b_l$) eines Magnetfelds, die von einer Reihe (25) von Detektoren (27) empfangen werden, die in Bezug zum elektrischen Leiter (15A) positioniert sind, wobei die Position jedes Detektors in Bezug zu einem Referenzpunkt (Pr) bekannt ist, sodass die Abstände ($r_i$) zwischen diesem letzteren und den Messpunkten ($Pm_i$) welche die Detektoren (27) darstellen, bestimmt werden, wobei der Rechner **dadurch gekennzeichnet ist, dass** er angepasst ist, um die folgenden Schritte umzusetzen:

- Erhalten (110) einer Berechnungsmatrix M, die eine Reihe von Begriffen umfasst, die in eine endliche Anzahl von Zeilen und eine endliche Anzahl von Spalten aufgeteilt sind,

wobei die Berechnungsmatrix M (110) in Abhängigkeit von den Koordinaten von Messpunkten (Pm$_i$) in Bezug auf den Referenzpunkt (Pr) erhalten wird,

die Positionierung der Reihe (25) von Detektoren (27) in Bezug auf den elektrischen Leiter (15A) so ist, dass bei einem ersten Abstand (d1), der zwischen dem Referenzpunkt (Pr) und dem Punkt des Leiters (15A) definiert ist, der dem Referenzpunkt (Pr) am nächsten liegt, das Maximum der Abstände (r$_i$) der Messpunkte (Pm$_i$) in Bezug auf den Referenzpunkt (Pr) streng kleiner ist als der erste Abstand (d1), und die Messpunkte (Pm$_i$) entlang eines Kreises mit dem Referenzpunkt (Pr) als Mittelpunkt oder einer Kugel mit dem Referenzpunkt (Pr) als Mittelpunkt angeordnet sind,

wobei jeder Begriff einer gleichen Zeile der Berechnungsmatrix (M) proportional zum gleichen Abstand (r$_i$) zwischen dem Messpunkt (Pm$_i$) und dem Referenzpunkt (Pr) ist, der mit einer Leistung größer oder gleich Null angehoben ist, wobei jede Spalte der Berechnungsmatrix (M) mit einer Leistung angehoben, die sich von den anderen Spalten unterscheidet,

- Empfangen von Messungen von Komponentenwerten (b$_l$) des Magnetfelds von der Reihe (25) von Detektoren (27), wobei jede Komponente (b$_l$) in einer Richtung (Dmr, Dmθ, Dθ, D(p, Dr) an einem Messpunkt (Pm$_i$) genommen wird, wobei jeder Messpunkt (Pm$_i$), der einer Richtung (Dmr, Dmθ, Dθ, Dφ, Dr) zugeordnet ist, sich von den anderen Messpunkten (Pm$_i$), die derselben Richtung (Dmr, Dmθ, Dθ, D(p, Dr) zugeordnet sind, unterscheidet,
- Bilden (120) eines Messvektors B, der die empfangenen Messungen von Komponentenwerten (b$_l$) beinhaltet,
- Berechnen (130) von Komponenten (α) eines Koeffizientenverktors A, wobei der Vektor A so viele Komponenten (α) umfasst, wie die Matrix M Spalten umfasst, und die Matrixbeziehung B = M x A überprüft, wobei x die Matrixmultiplikationsoperation angibt, sodass jede berechnete Komponente (α) einem Koeffizienten einer Zerlegung des Magnetfelds in räumliche Oberschwingungen entspricht und proportional zur Intensität (IA) des Stromes im elektrischen Leiter (15A) ist, und
- Bestimmen (140) der Intensität (IA) des Stroms im elektrischen Leiter (15A) aus mindestens den berechneten Komponenten.

8. Stromsensor (20), der zum Messen einer Intensität (IA) eines Stromes konfiguriert ist, der durch einen elektrischen Leiter (15A) fließt, wobei der Stromsensor (20) eine Vielzahl von Magnetfelddetektoren (27) und einen Rechner (30) nach Anspruch 7 umfasst, wobei jeder Detektor (27) zum Messen des Werts des Magnetfelds in einer Richtung (Dmr, Dmθ, Dθ, D(p, Dr) an einem Messpunkt (Pm$_i$) konfiguriert ist, wobei sich jeder Messpunkt (Pm$_i$) von einem Referenzpunkt (Pr) unterscheidet und in einem Abstand (r$_i$) davon ist, und zum Übermitteln des Messwerts zum Rechner (30).

9. Strommesssystem (IA, IB), das eine Vielzahl von elektrischen Leitern (15A, 15B) durchläuft, wobei das Messsystem eine Vielzahl von Stromsensoren (20) nach Anspruch 8 und eine einzige zentrale Steuerung umfasst, wobei jeder Sensor (20) zum Kommunizieren mit der zentralen Steuerung konfiguriert ist.

**Claims**

1. Method for measuring the intensity (IA) of a current in an electrical conductor (15A) based on measurements of values of components (b$_l$) of a magnetic field received from a set (25) of detectors (27) positioned relative to the electrical conductor (15A), the position of each detector being known relative to a reference point (Pr) so that the distances (r$_i$) between the latter and the measuring points (Pm$_i$) made up of the detectors (27) are determined, the method comprising the steps of:

- obtaining (110) a calculation matrix M comprising a set of terms (T) divided into a finite number of lines and a finite number of columns,
said calculation matrix M being obtained (110) as a function of the coordinates of measuring points (Pm$_i$) with respect to the reference point (Pr),
the positioning of the set (25) of detectors relative to the electrical conductor (15A) being such that, with a first distance (d1) defined between the reference point (Pr) and the point of the conductor (15A) closest to the reference point (Pr), the maximum of the distances (r$_i$) of the measuring points (Pm$_i$) relative to the reference point (Pr) is strictly less than the first distance (d1), and the measuring points (Pm$_i$) being arranged along a circle with the reference point (Pr) as its centre or a sphere with the reference point (Pr) as its centre,
each term (T) of a same row of the calculation matrix (M) being proportional to the same distance ($r_i$) between a measurement point ($Pm_i$) and the reference point (Pr), raised to a power greater than or equal to zero, each column of the calculation matrix (M) being raised to a power different from the other columns,

- forming (120) a measurement vector B including the measurements of component values ($b_l$) received from said set (25) of detectors (27), each component ($b_l$) being taken according to a direction (Dmr, Dm$\vartheta$, D$\theta$, D$\varphi$, Dr) at a measuring point ($Pm_i$), each measuring point ($Pm_i$) associated with a direction (Dmr, Dm$\vartheta$, D$\theta$, Dq>, Dr) being distinct from the other measuring points ($Pm_i$) associated with the same direction (Dmr, Dm$\vartheta$, D$\theta$, Dq>, Dr),
- calculating (130) components ($\alpha$) of a vector of coefficients A, the vector A comprising as many components ($\alpha$) as the matrix M comprises columns and satisfying the matrix relationship B = M x A, x denoting the matrix multiplication operation, so that each calculated component ($\alpha$) corresponds to a coefficient of a breakdown of the magnetic field into spatial harmonics and is proportional to the intensity (IA) of the current in the electrical conductor (15A), and
- determining (140) the intensity (IA) of the current in the electric conductor (15A) from at least the calculated components ($\alpha$).

2. Method according to claim 1, wherein the steps of obtaining (110) a calculation matrix (M) and of calculation (130) are dependent on parameters of the sensor (20), the method furthermore comprising:

- an optimisation step (150) comprising obtaining at least one optimised parameter, such as the actual position of the reference point (Pr) with respect to the electrical conductor (15A),
- a step (160) of calculating at least one conversion coefficient (K) from the optimised parameter(s),
- the determination step (140) comprising implementing the division of an actual value of a coefficient ($\alpha$) by the conversion coefficient (K).

3. Method according to claim 2, wherein the obtaining step (160) is implemented by searching for a set of optimised parameters minimising the difference between at least two ratios between two components ($\alpha$) of the vector of coefficients (A) obtained during the step (130) of calculating the components ($\alpha$) and two ratios between two intermediate components ($\alpha_i$), each intermediate component ($\alpha_i$) being a component of a vector of coefficients (A) calculated for a possible set of parameters of the sensor (20).

4. Method according to any one of claims 1 to 3, wherein a first distance (d1) is defined between the reference point (Pr) and the point of the conductor (15A) closest to the reference point (Pr), the maximum of the distances of the measuring points ($Pm_i$) being less than or equal to 85% of the first distance (d1).

5. Method according to any one of claims 1 to 4, wherein a first distance (d1) is defined between the reference point (Pr) and the point of the conductor (15A) closest to the reference point (Pr), the first distance (d1) being less than or equal to 10 centimetres and each power being less than or equal to 5.

6. Method for designing a measurement sensor including a plurality of magnetic field detectors (27), the design method determining, for a desired measurement accuracy, the number of magnetic field detectors (27), as well as the spatial positioning of the detectors (27), using the measurement method according to any one of claims 1 to 5.

7. Calculator (30) for measuring the intensity (IA) of a current in an electrical conductor (15A) based on measurements of values of components ($b_l$) of a magnetic field received from a set (25) of detectors (27) positioned relative to the electrical conductor (15A), the position of each detector being known relative to a reference point (Pr) so that the distances ($r_i$) between the latter and the measuring points ($Pm_i$) that make up the detectors (27) are determined, the control unit being **characterised in that** it is adapted to implement the following steps:

- obtaining (110) a calculation matrix M comprising a set of terms, divided into a finite number of rows and a finite number of columns,
said calculation matrix M being obtained (110) as a function of the coordinates of measuring points ($Pm_i$) with respect to the reference point (Pr),
the positioning of the set (25) of detectors (27) relative to the electrical conductor (15A) being such that, with a first distance (d1) defined between the reference point (Pr) and the point of the conductor (15A) closest to the reference point (Pr), the maximum of the distances ($r_i$) of the measuring points ($Pm_i$) relative to the reference point (Pr) is strictly less than the first distance (d1), and the measuring points ($Pm_i$) being arranged along a circle with the reference point (Pr) as its centre or a sphere with the reference point (Pr) as its centre,

each term of a same row of the calculation matrix (M) being proportional to the same distance ($r_i$) between the measuring point ($Pm_i$) and the reference point (Pr), raised to a power greater than or equal to zero, each column of the calculation matrix (M) being raised to a power different from the other columns,

- receiving measurements of values of components ($b_l$) of the magnetic field from said set (25) of detectors (27), each component ($b_l$) being taken according to a direction (Dmr, Dm$\vartheta$, D$\theta$, Dq>, Dr) at a measuring point ($Pm_i$), each measuring point ($Pm_i$) associated with a direction (Dmr, Dm$\vartheta$), D$\theta$, Dq>, Dr) being distinct from the other measuring points ($Pm_i$) associated with the same direction (Dmr, Dm$\theta$, D$\theta$, Dcp, Dr),
- forming (120) a measurement vector B including the measurements of received component values ($b_l$),
- calculating (130) components ($\alpha$) of a vector of coefficients A, the vector A comprising as many components ($\alpha$) as the matrix M comprises columns and satisfying the matrix relationship B = M x A, x denoting the matrix multiplication operation, so that each calculated component ($\alpha$) corresponds to a coefficient of a breakdown of the magnetic field into spatial harmonics and is proportional to the intensity (IA) of the current in the electrical conductor (15A), and
- determining (140) the intensity (IA) of the current in the electric conductor (15A) from at least the calculated components.

8. Current sensor (20) configured to measure an intensity (IA) of a current passing through an electrical conductor (15A), the current sensor (20) comprising a plurality of magnetic field detectors (27) and a calculator (30) according to claim 7, each detector (27) being configured to measure the value of the magnetic field according to a direction (Dmr, Dm$\vartheta$, D$\theta$, Dq>, Dr) at one measuring point ($Pm_i$), each measuring point ($Pm_i$) being distinct and at a distance ($r_i$) from a reference point (Pr), and to transmit the measured value to the calculator (30).

9. A system for measuring currents (IA, IB) passing through a plurality of electrical conductors (15A, 15B), the measurement system comprising a plurality of current sensors (20) according to claim 8 and a single central controller, each sensor (20) being configured to communicate with the central controller.

Fig.1

Fig.2

Fig.3

*Fig.4*

-110c-

-120c-

-130c-

-160-

150

*Fig.5*

**RÉFÉRENCES CITÉES DANS LA DESCRIPTION**

**Documents brevets cités dans la description**

- WO 2015030871 A1

- WO 2013068360 A1